# EUROPEAN PATENT APPLICATION

(11) **EP 3 310 142 A1**
(43) Date of publication of application: **18.04.2018**
(21) Application number: 16811539.2
(22) Date of filing: 09.06.2016
(51) Int. Cl.: H05K 7/20, B32B 7/02, B32B 27/00

(54) **DEVICE HEAT DISSIPATION METHOD**

(30) Priority: 15.06.2015 JP 2015120541
(71) Applicant: Loveox Co., Ltd., Tokyo, 174-0051 (JP); Shin-Etsu Chemical Co., Ltd., Tokyo 100-0004 (JP)
(72) Inventor: NISHIO, Koji, Tokyo 174-0051 (JP); USHIJIMA, Wataru, Tokyo 174-0051 (JP); SUMIYOSHI, Ryoichi, Tokyo 100-0004 (JP); ISHIHARA, Yasuhisa, Annaka-shi Gunma 379-0224 (JP)
(74) Representative: Michalski Hüttermann & Partner Patentanwälte mbB
(86) International application number: PCT/JP2016/067207
(87) International publication number: WO 2016/204064

(57) **Abstract**

According to this method of heat dissipation, a first heat dissipation sheet is pasted on an internal wall surface of a wall of a housing, and a second heat dissipation sheet is pasted on an external wall surface of the wall of the housing so that the wall of the housing is positioned between the first heat dissipation sheet and the second heat dissipation sheet. The first and the second heat dissipation sheets include a heat conductive layer, a heat radiation layer adjacent to a first surface of the heat conductive layer, and a base adjacent to a second surface of the heat conductive layer. The base contains a heat conductive silicone resin having hardness of 40 or less in ASKER C.

## Description

### Technical Field

The present invention relates to a method of heat dissipation for an apparatus.

### Background Art

Various electrical apparatuses (e.g., a control panel, a personal computer, and an electronic substrate) often go wrong in operation or break down because of ambient temperature or heat generated by the apparatuses' own electric components (self-heating). For these reasons, such electrical apparatuses are equipped with various kinds of cooling apparatuses. Known cooling apparatuses include a cooler, a cooling fan, a heat sink, and the like.

However, a cooler and a cooling fan have problems that they require high running costs, they are not easy for maintenance, and they themselves can break down. Further, with respect to a heat sink, a larger size (volume, contact area) of a heat sink itself is required to improve its heat conductive effect, and thus there are problems that a space for installation is confined, and the like. In addition, an application of, for example, silicone grease between a heat sink and a heating component is generally required, and the silicone grease is volatile, and thus the silicone grease required to be applied periodically, which is a problem that it is not easy for maintenance.

### Citation List

### Patent Literature

Patent Literature 1: JP 2006-298703 A

### Summary of Invention

### Technical Problem

The present invention has been made in view of the circumstances as mentioned above. An object of the present invention is to provide a method of heat dissipation for an apparatus, which is low in cost and free from complicated maintenance.

### Solution to Problem

A method of heat dissipation according to the present invention is a method of heat dissipation for an apparatus having a heat generation source inside a housing. In the method, a first heat dissipation sheet is pasted on an internal wall surface of a wall of the housing, and a second heat dissipation sheet is pasted on an external wall surface of the wall of the housing so that the wall of the housing is positioned between the first heat dissipation sheet and the second heat dissipation sheet. The first and the second heat dissipation sheets include a heat conductive layer, a heat radiation layer adjacent to a first surface of the heat conductive layer, and a base adjacent to a second surface of the heat conductive layer. The base contains a heat conductive silicone resin having hardness of 40 or less in ASKER C.

In one embodiment of the present invention, a first heat dissipation sheet and a second heat dissipation sheet are pasted on wall surfaces so that their bases are contact with the wall surfaces. Further, the first heat dissipation sheet or the second heat dissipation sheet is pasted on a wall close to a heat generation source. The base contains a heat conductive silicone resin having hardness of 40 or less in ASKER C. In addition, the first heat dissipation sheet or the second heat dissipation sheet has an area 10 or more times as large as the area of the heat generation source.

### Advantageous Effects of Invention

The present invention can provide a method of heat dissipation for an apparatus, which is low in cost and requires no complicated maintenance.

### Brief Description of Drawings

Fig. 1 is a cross-sectional view showing a configuration of a heat dissipation sheet 10 used in a method of heat dissipation of the present embodiment.
Fig. 2 is an example of an external configuration of an electrical apparatus (control panel 100) which is a target of the method of heat dissipation of the present embodiment.
Fig. 3 is a schematic diagram showing a method for using the heat dissipation sheet 10 in the method of heat dissipation of the present embodiment.
Fig. 4 is a schematic diagram showing the method for using the heat dissipation sheet 10 in the method of heat dissipation of the present embodiment.
Fig. 5 is a schematic diagram showing the method for using the heat dissipation sheet 10 in the method of heat dissipation of the present embodiment.
Fig. 6 is a schematic diagram showing the method for using the heat dissipation sheet 10 in the method of heat dissipation of the present embodiment.
Fig. 7 is a schematic diagram showing the method for using the heat dissipation sheet 10 in the method of heat dissipation of the present embodiment.
Fig. 8 is a graph showing an effect of the method of heat dissipation of the present embodiment.

### Description of Embodiments

The method of heat dissipation according to the embodiment of the present invention is described below in detail with reference to the accompanying drawings.

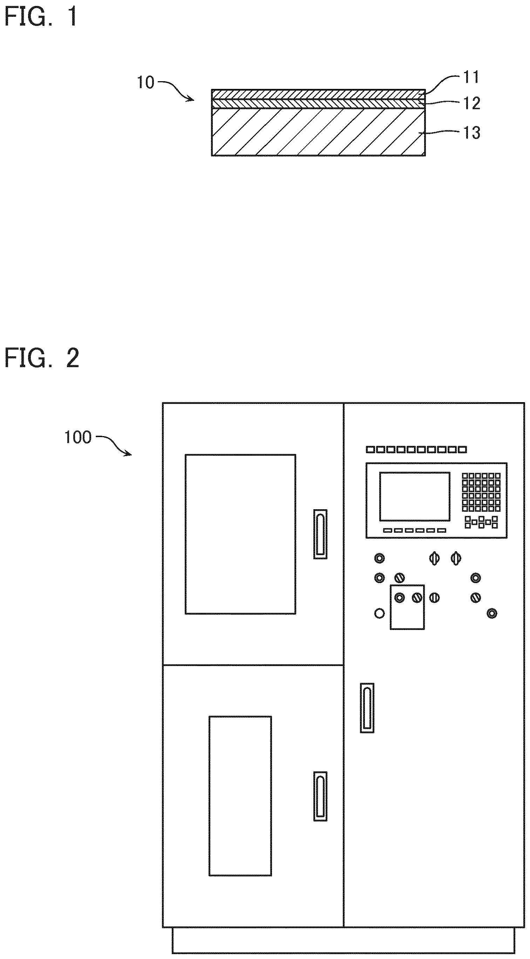

Fig. 1 illustrates a configuration of a heat dissipation sheet 10 used in the method of heat dissipation of the embodiment. Fig. 1 shows a cross-sectional view of the heat dissipation sheet 10. The heat dissipation sheet 10 includes a laminated structure comprising a heat radiation layer 11, a heat conductive layer 12, and a heat conductive base 13. The heat radiation layer 11 is laminated to a front side of the heat conductive layer 12, and then the heat conductive base 13 is laminated to a reverse side of the heat conductive layer 12. The heat radiation layer 11 has a high heat radiation rate, and has a function of absorbing or radiating heat of the surrounding area. The heat conductive layer 12 has functions of conducting heat of the heat conductive base 13 to the heat radiation layer 11, and, on the contrary, conducting heat of the heat radiation layer 11 to the heat conductive base 13. The heat conductive base 13 is formed to have high heat conductivity, and also to have sufficient flexibility so that the heat conductive base 13 can be pasted on objects having various shapes. Examples of a method for forming the laminated structure include, but not limited to, a pasting method, a coating method, a pressing method, and the like.

The method of heat dissipation of the present embodiment dissipates heat of an electrical apparatus such as a control panel 100 shown in Fig. 2, by pasting the heat dissipation sheet 10 to a certain place of the electrical apparatus. A method for pasting the heat dissipation sheet 10 and others are described below. The average dimensions of control panel 100 shown in Fig. 2 are, by way of example, 150 cm high by 1 m wide by 80 cm deep. The method of heat dissipation of the present embodiment is not limited for use in the apparatus as described in the figure, but can be applied to various apparatuses which radiate heat from the inside of the apparatuses.

Next, details of the heat radiation layer 11, the heat conductive layer 12, and the heat conductive base 13, which constitute the heat dissipation sheet 10, are described one by one below.

### [Heat radiation layer 11]

The heat radiation rate of the heat radiation layer 11 is set at 0.80 or more, preferably 0.80 to 0.99. When the heat radiation rate is less than 0.80, a sufficient heat dissipation effect cannot always be attained. Examples of the material of the heat radiation layer 11 include, but are not limited to, an organic resin layer comprising one type of or two or more types of particles having a high heat radiation rate such as a powder of ceramic including silica, alumina, titanium oxide, boron nitride, or aluminum nitride, a cordierite powder, or graphite. Examples of the organic resin include, but of course are not limited to, an acrylic resin, a silicone resin, an epoxy resin, a urethane resin, a polyester resin, or the like. In this case, the particle size of the above-described particle is set at 0.1 to 50 µm, more preferably set at 1 to 10 µm.

The above-described particle can be produced by grinding the above-described materials into fine particles with a mill such as a ball mill or a jet mill. In this connection, the value of the above-described particle size is obtained by measurement using Microtrac size distribution analyzer MT3300EX available from NIKKISO CO., LTD. The average particle size is represented as a volumetric particle size. A heat radiation rate of the fine particles is preferably 0.80 to 0.99, more preferably 0.85 to 0.99. Further, the above-described particle is preferably used about 40 to 200 parts by mass, specifically about 50 to 150 parts by mass based on 100 parts by mass of the organic resin. When the amount of the particle included is excessively small, a sufficient heat radiation property cannot always be attained, and, on the contrary, when the amount is excessively large, it can be difficult to fill up with the fine particle.

Further, the above-described materials are shown only by way of example, and thus various materials can be adopted as long as desired flexibility and heat radiation characteristics can be achieved.

A commercially available heat radiation layer can also be used as the heat radiation layer 11. Examples of the heat radiation layer which can be used include Cerac α (a heat radiation rate 0.96) manufactured by CERAMISSION, CO., LTD., and PELCOOL (a powder-containing acrylic resin) manufactured by Pelnox, Ltd.

Further, a thickness of the heat radiation layer 11 can be set at 10 to 100 µm, preferably 20 to 50 µm. When the thickness is less than 10 µm, processing the heat radiation layer 11 is difficult. When the thickness is more than 100 µm, flexibility of the heat radiation layer 11 is reduced. In this connection, the above-described heat radiation rate is obtained by measurement using a thermal emissivity meter AERD manufactured by Kyoto Electronics Manufacturing Co., Ltd.

### [Heat conductive layer 12]

A heat conductive layer 12 is made with a material having a heat conductivity in a plane direction of 200 W/mK or more, preferably 200 to 2000 W/mK. The heat conductive layer 12 can be made with a graphite sheet, aluminum foil, or copper foil. Although the graphite sheet has insufficient bending strength and tensile strength, the graphite sheet has an extremely excellent in-plane heat conductivity, and thus the graphite sheet is preferred. The aluminum foil or the copper foil has high bending strength and tensile strength, and can be made at a low cost, and thus the aluminum foil or the copper foil has advantage over the graphite sheet.

Further, a thickness of the heat conductive layer 12 is 0.01 to 0.1 mm, preferably 0.03 to 0.1 mm, more preferably 0.03 to 0.08 nm. When the thickness of the heat conductive layer 12 is excessively thin, the heat dissipation sheet 10 as a whole lacks rigidity, and thus it is hard to handle the heat dissipation sheet 10. On the other hand, when the thickness is over 0.1 mm, flexibility of the heat dissipation sheet 10 can be impaired. Further, when the heat dissipation sheet 10 is pasted on an electrical apparatus 100, it can be difficult to paste the heat dissipation sheet 10 on, for example, a curved wall surface.

Note that, MORGEN sheet (a heat radiation sheet comprising aluminum foil as a heat conductive layer laminated with a heat radiation polyester resin as the heat radiation layer) manufactured by Asari Denki Co, Ltd. can be used as the heat radiation layer 11 and the heat conductive layer 12.

### [Heat conductive base 13]

A heat conductive base 13 is made to have heat conductivity of 1.4 W/mK or more, preferably 2.0 W/mK or more. The upper limit of the heat conductivity is not particularly specified, but the heat conductivity is commonly 10 W/mK or less. Such heat conductivity can be achieved by inclusion of a certain amount of a heat conductive filler in a silicone composition used for a silicone resin layer. In this connection, the value of the heat conductivity of the heat conductive base 13 is obtained by measurement using a thermal conductivity meter TPA-501 available from Kyoto Electronics Manufacturing Co., Ltd. Details of the silicone composition, which constitutes the heat conductive base 13, are described below.

A thickness of the heat conductive base 13 is 0.2 mm or more, preferably 0.5 mm or more, more preferably 1 mm or more. When the thickness of the heat conductive base 13 is larger, temperature-lowering effect in the electrical apparatus 100 can be higher, and thus the thicker heat conductive base 13 is preferred. When the thickness is excessively small, the heat conductive base 13 is ineffective for heat storage before conducting the heat to the heat conductive layer 12 and the heat radiation layer 11, which results in impaired heat dissipation properties of the heat dissipation sheet 10. The upper limit of the heat conductive base 13 is not specifically limited, however, from the viewpoint of actual mass in use, the thickness is set at 15 mm or less, preferably 10 mm or less, more preferably 5 mm or less.

Further the heat conductive base 13 can be made with, for example, a silicone resin. The heat conductive base 13 is made to have a certain level or more of flexibility so that the heat dissipation sheet 10 can be pasted on objects having various shapes. For example, hardness of the heat conductive base 13 is set at 40 or less in ASKER C, more preferably 30 or less. When the hardness is over 40, fitting with a heat generation object is insufficient, which results in a problem of increase in contact thermal resistance. Such ASKER C hardness can be achieved by controlling silicone resin content and organohydrogenpolysiloxane content in a silicone composition used for a silicone resin layer which constitutes the heat conductive base 13.

Details of the silicone composition constituting the heat conductive base 13 are described below.

A silicone composition (A) containing the following components (a) to (d) can be adopted as the silicone composition in the heat conductive base 13.
(a) An organopolysiloxane having 2 or more alkenyl groups bonded to silicon atoms per molecule, wherein the organopolysiloxane is represented by an average composition formula RₐSiO_{(4-a)/2} (wherein R is independently an unsubstituted or substituted monovalent hydrocarbon group having 1 to 12 carbon atoms, a is a positive number of 1.8 to 2.2) (100 parts by mass)
(b) A heat conductive filler: 200 to 4000 parts by mass
(c) An organohydrogenpolysiloxane having 2 or more hydrogen atoms bonded to silicon atoms per molecule (an amount in which a molar ratio of hydrogen atoms directly bonded to the silicon atoms in the component (c) relative to the alkenyl groups in the component (a) is 0.5 to 5.0)
(d) A platinum group compound (0.1 to 1000 ppm of the component (a) as a platinum group compound content)

Further, a silicone composition (B) containing the following components (b), (f), and (g) can be adopted as the silicone composition in the heat conductive base 13.
(b) A heat conductive filler (100 to 3000 parts by mass)
(f) A silicone resin (100 parts by mass)
(g) Organic peroxide compounds (0.1 to 2 parts by mass calculated as an organic peroxide)

Next, each of the components (a) to (d) contained in the above-described silicone composition (A) is further described in detail.

### [(a) Organopolysiloxane]

An alkenyl group-containing organopolysiloxane, which is the component (a), is an organopolysiloxane having 2 or more, preferably 2 to 100 alkenyl groups bonded to silicon atoms per molecule, wherein the alkenyl group-containing organopolysiloxane is represented by an average composition formula RₐSiO_{(4-a)/2} (wherein R is independently an unsubstituted or substituted monovalent hydrocarbon group having 1 to 12 carbon atoms, a is a positive number of 1.8 to 2.2, preferably 1.95 to 2.05), and the alkenyl group-containing organopolysiloxane is a base agent (base polymer) in an addition reaction curing composition.

Generally, the main chain portion of the alkenyl group-containing organopolysiloxane commonly comprises repeats of a diorganosiloxane unit. Although the alkenyl group-containing organopolysiloxane can contain a branched structure in a portion of the molecular structure or can be a cyclic form, a linear diorganopolysiloxane is preferred from the viewpoint of physical properties, such as mechanical strength of the cured material.

In the above-described chemical formula RₐSiO_{(4-a)/2}, R are the same or different kinds of unsubstituted or substituted monovalent hydrocarbon groups having 1 to 12 carbon atoms, specifically 1 to 10 carbon atoms. Examples of a functional group bonded to the silicon atom, except for alkenyl groups, include an alkyl group, such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; a cycloalkyl group, such as a cyclopentyl group, a cyclohexyl group, and a cycloheptyl group; an aryl group, such as a phenyl group, a tolyl group, a xylyl group, a naphthyl group, and a biphenylyl group; and an aralkyl group, such as a benzyl group, a phenylethyl group, a phenylpropyl group, and a methylbenzyl group; and also include a group in which a part of or all of hydrogen atoms bonded to the above-described groups are substituted by halogen atoms, such as fluorine, chlorine, and bromine, or by cyano groups, and examples of the group include a chloromethyl group, a 2-bromoethyl group, a 3-chloropropyl group, a 3,3,3-trifluoropropyl group, a chlorophenyl group, a fluorophenyl group, a cyanoethyl group, and a 3,3,4,4,5,5,6,6,6-nonafluorohexyl group. A representative group is a group having 1 to 10 carbon atoms, and a specifically representative group is a group having 1 to 6 carbon atoms, and the group is preferably an unsubstituted or substituted alkyl group having 1 to 3 carbon atoms, such as a methyl group, an ethyl group, a propyl group, a chloromethyl group, a bromoethyl group, 3,3,3-trifluoropropyl group, and a cyanoethyl group; and an unsubstituted or substituted phenyl group, such as a phenyl group, a chlorophenyl group, and a fluorophenyl group. Further, all of the functional groups, except for alkenyl groups bonded to silicon atoms, can be the same or different.

Further, examples of the alkenyl group commonly include an alkenyl group having about 2 to 8 carbon atoms, such as a vinyl group, an allyl group, a propenyl group, an isopropenyl group, a butenyl group, a hexenyl group, and a cyclohexenyl group. Among others, a lower alkenyl group, such as a vinyl group, and an allyl group are preferred, and especially a vinyl group is preferred among the above-described groups.

Kinematic viscosity of the organopolysiloxane at 25°C is commonly set at within a range of from 10 to 100000 mm²/s, more preferably from 500 to 50000 mm²/s. When the kinematic viscosity is excessively low, storage stability of the obtained composition can be poor. When the kinematic viscosity is excessively high, extensibility of the obtained composition can be poor. In the embodiment, the kinematic viscosity can be measured with an Ostwald viscometer. Further, the organopolysiloxane, which is component (a), can be made with only one kind of material, or with two or more kinds of materials having different kinematic viscosity.

### [(b) Heat conductive filler]

A heat conductive filler, which is filled into a heat conductive silicone composition, used includes a nonmagnetic metal, such as copper, and aluminum; a metal oxide, such as alumina, silica, magnesia, ferric oxide red, beryllia, titania, zirconia, and zinc oxide; a metal nitride, such as aluminum nitride, silicon nitride, and boron nitride; a metal hydroxide, such as aluminum hydroxide, and magnesium hydroxide; and a material generally known as a heat conductive filler, such as a synthetic diamond or silicon carbide. One type of the heat conductive filler can be used alone, or two or more types can be used in combination.

An average particle size of the heat conductive filler can be set at 0.1 to 200 µm, preferably 0.1 to 100 µm, more preferably 0.5 to 50 µm. In this connection, the average particle size can be measured with Microtrac size distribution analyzer MT3300EX (NIKKISO CO., LTD.). The average particle size is represented as a volumetric particle size.

An amount of the heat conductive filler included can be 200 to 4000 parts by mass, more preferably 200 to 3000 parts by mass based on 100 parts by mass of the component (a). When an amount of the heat conductive filler included is, a sufficient heat conductivity of a heat conductive base 13 cannot always be attained. On the contrary, when an amount included is excessively large, moldability can be deteriorated, and adhesiveness can be reduced.

### [(c) Organohydrogenpolysiloxane]

An organohydrogenpolysiloxane, which is component (c), is an organohydrogenpolysiloxane having 2 or more, preferably 2 to 100 hydrogen atoms bonded to silicon atoms (SiH groups) per molecule, and acts as a cross-linker to the component (a) . That is, in the presence of a platinum group compound, which is component (d) as described below, hydrogen atoms bonded to silicon atoms in the component (c) are added to alkenyl groups in the component (a) by a hydrosilylation reaction to provide a cross-linked cured material having a three dimensional network structure containing cross-linkages.

Examples of an organic group bonded to a silicon atom in the component (c) include an unsubstituted or substituted monovalent hydrocarbon group having no aliphatic unsaturated bond and the like. Specifically, the organic group includes unsubstituted or substituted monovalent hydrocarbon groups which are the same kind as the above-exemplified groups bonded to a silicon atom, except for the aliphatic unsaturated groups, and then a methyl group is preferred among the above-described groups from the viewpoints of ease in synthesis and economy.

A structure of the organohydrogenpolysiloxane, which is component (c) of the present invention, is not specifically limited, and although the structure can be any of linear, branched, or cyclic structure, the linear structure is preferred. Further, a degree of polymerization (the number of silicon atoms) of the organohydrogenpolysiloxane is preferably 2 to 100, specifically preferably 2 to 50.

Specific examples of a preferred organohydrogenpolysiloxane, which is component (c), include:
a methylhydrogenpolysiloxane in which both ends of the molecular-chain are capped with trimethylsiloxy groups,
a dimethylsiloxane/methylhydrogensiloxane copolymer in which both ends of the molecular-chain are capped with trimethylsiloxy groups,
a dimethylsiloxane/methylhydrogensiloxane/methylphenylsilox ane copolymer in which both ends of the molecular-chain are capped with trimethylsiloxy groups,
a dimethylpolysiloxane in which both ends of the molecular-chain are capped with dimethylhydrogensiloxy groups,
a dimethylsiloxane/methylhydrogensiloxane copolymer in which both ends of the molecular-chain are capped with dimethylhydrogensiloxy groups, and
a methylphenyl polysiloxane in which both ends of the molecular-chain are capped with dimethylhydrogensiloxy groups.

Note that, one type of the organohydrogenpolysiloxane, which is component (c), can be used alone, or two or more types can be used in combination.

An amount of the component (c) included can be adjusted to an amount so that SiH groups in the component (c) is 0.5 to 5.0 mol, more preferably 0.8 to 4.0 mol relative to 1 mol of the alkenyl groups in the component (a). When the amount of SiH groups in the component (c) is less than 0.5 mol relative to 1 mol of the alkenyl groups in the component (a), problems can occur, for example, the composition cannot be cured, or strength of the cured material can be insufficient, and thus the material cannot be handled as a formed material or a composite material. On the other hand, when an amount is over 5.0 mol, there is a risk that adhesiveness of the surface of the cured material is insufficient.

### [(d) Platinum group compound]

A platinum group compound in the component (d) is a catalyst component included for accelerating an addition reaction of alkenyl groups in the above-described component (a) with hydrogen atoms bonded to silicon atoms in the component (c) to convert the composition of the present embodiment into the cross-linked cured material having a three dimensional network structure.

The component (d) can be selected from known catalysts used for a common hydrosilylation reaction as desired, and the selected catalyst can be used. Specific examples include a simple substance of a platinum group metal, such as platinum (including platinum black), rhodium, and palladium; platinum chloride, chloroplatinic acid, and chloroplatinate, such as H₂PtCl₄·nH₂O, H₂PtCl₆·nH₂O, NaHPtCl₆·nH₂O, KHPtCl₆·nH₂O, Na₂PtCl₆·nH₂O, K₂PtCl₄·nH₂O, PtCl₄·nH₂O, PtCl₂, and Na₂HPtCl₄·nH₂O (wherein n is an integer of 0 to 6, preferably 0 or 6) ; an alcohol-modified chloroplatinic acid; a complex of chloroplatinic acid with an olefin; a material in which a platinum group metal, such as platinum black, and palladium is supported by a carrier such as alumina, silica, and carbon; a rhodium-olefin complex; chlorotris(triphenylphosphine)rhodium (Wilkinson's catalyst); and a complex of platinum chloride, chloroplatinic acid, or chloroplatinate with a vinyl group-containing siloxane. One type of the platinum group compound can be used alone, or two or more types can be used in combination.

Further, any amount of the platinum group compound in the above-described component (d) can be included as long as it is an effective amount required for curing the composition. Generally, the amount can be set at about 0.1 to 1000 ppm calculated as a mass of a platinum group metal relative to the component (a), preferably set at about 0.5 to 500 ppm.

Further, a reaction controlling agent can be included as required. The reaction controlling agent has a function of controlling a rate of hydrosilylation reaction, which is an addition reaction of the component (a) with the component (c) proceeding in the presence of the component (d). Such the reaction controlling agent can be selected from known addition reaction controlling agents used for a common addition reaction curing silicone composition as desired. Specific examples include an acetylene compound, such as 1-ethynyl-1-cyclohexanol, 3-butyn-1-ol, and ethynyl methylidene carbinol; a nitrogen compound; an organophosphorus compound; a sulfur compound; an oxime compound; and an organic chlorine compound. One type of the reaction controlling agent can be used alone, or two or more types can be used in combination.

An amount of the reaction controlling agent varies according to the amount of the component (d) used. Generally, it is sufficient that the reaction controlling agent included can control an advancement of the hydrosilylation reaction to a desired reaction rate. Generally, the reaction controlling agent included is preferably about 10 to 50000 ppm relative to the mass of the component (a).

Next, each of the components (b), (f), and (g) contained in the above-described silicone composition (B) is further described in detail. Since the component (b) is the same as that of the silicone composition (A), components (f) and (g) are described below.

### [(f) Silicone resin]

A silicone resin, which is component (f), has a function of imparting adhesiveness to the surface of the cured material formed by curing the heat conductive silicone composition. Examples of such the silicone resin include a silicone resin which is a copolymer of R¹₃SiO_{1/2} unit (M unit) and SiO_{4/2} unit (Q unit), in which a ratio between M unit and Q unit (molar ratio), M/Q, is 0.5 to 1.5, preferably 0.6 to 1.4, more preferably 0.7 to 1.3. When the above-described M/Q is within the above-described range, a desired adhesion can be obtained. Further, R¹₂SiO_{2/2} (D unit) or R¹SiO_{3/2} unit (T unit) can be included as desired, the amount of the D unit and T unit included is set at 15 mol% or less, more preferably 10 mol% or less.

R¹ in the general formula representing the above-described M unit or the like is an unsubstituted or substituted monovalent hydrocarbon group, preferably an unsubstituted or substituted monovalent hydrocarbon group containing no aliphatic unsaturated combination. Examples of the R¹ include an alkyl group, such as a methyl group, an ethyl group, a propyl group, an isopropyl group, a butyl group, an isobutyl group, a tert-butyl group, a pentyl group, a neopentyl group, a hexyl group, a heptyl group, an octyl group, a nonyl group, a decyl group, and a dodecyl group; a cycloalkyl group, such as a cyclopentyl group, a cyclohexyl group, and a cycloheptyl group; an aryl group, such as a phenyl group, a tolyl group, a xylyl group, a naphthyl group, and a biphenylyl group; and an aralkyl group, such as a benzyl group, a phenylethyl group, a phenylpropyl group, and a methylbenzyl group; and also include a group in which a part of or all of hydrogen atoms bonded to the above-described groups are substituted by halogen atoms, such as fluorine, chlorine, and bromine, or by cyano groups, and examples of the group include such a group having 1 to 12 carbon atoms, preferably 1 to 6 carbon atoms, such as a chloromethyl group, a 2-bromoethyl group, a 3-chloropropyl group, a 3,3,3-trifluoropropyl group, a chlorophenyl group, a fluorophenyl group, a cyanoethyl group, and a 3,3,4,4,5,5,6,6,6-nonafluorohexyl group.

Among the above-described groups, R¹ is preferably an unsubstituted or substituted alkyl group having 1 to 3 carbon atoms, such as a methyl group, an ethyl group, a propyl group, a chloromethyl group, a bromoethyl group, 3,3,3-trifluoropropyl group, and a cyanoethyl group; and an unsubstituted or substituted phenyl group, such as a phenyl group, a chlorophenyl group, and a fluorophenyl group. All of the R¹ can be the same or different. All of the R¹ are preferably methyl groups from the viewpoints of cost, ease of availability, chemical stability, load on the environment, and the like, as long as a specific property such as solvent resistance is not required.

When the component (f) is included, an amount included is preferably 50 to 500 parts by mass, more preferably 60 to 350 parts by mass, further more preferably 70 to 250 parts by mass based on 100 parts by mass of the component (a). When the amount of the component (f) included is less than 50 parts by mass, or more than 500 parts by mass, desired adhesiveness cannot always be obtained. Although the component (f) is a solid or a viscous liquid at room temperature in itself, the component (f) can be used in a dissolved state in a solvent. In this connection, the amount in the composition added is determined by an amount excluding the amount of the solvent.

### [(g) Organic peroxide compounds]

A curing reaction of the silicone composition with an organic peroxide occurs when a radical polymerization of the linear organopolysiloxanes, which have alkenyl groups such as vinyl groups either at one or both of an end of the molecular-chain (one end or both ends) and a non-end portion of the molecular-chain, is carried out in the presence of organic peroxide compounds. Examples of the organic peroxide compound, which is component (g), include diacyl peroxide, a dialkyl peroxide, and the like. The organic peroxide compound is not resistant to light or heat, and is unstable, and a solid organic peroxide compound is hard to be dispersed in a composition. Thus, the organic peroxide compound is, in most cases, used in a diluted state in an organic solvent, or in a dispersed state in a silicone component.

An amount of organic peroxide compounds included is preferably set at 0.1 to 2 parts by mass, more preferably set at 0.1 to 1.6 parts by mass calculated as an organic peroxide based on 100 parts by mass of the (f) silicone resin. When the amount included is excessively small, the curing reaction cannot always proceed sufficiently, and, on the contrary, when the amount is excessively large, stability of the composition can be impaired.

### [(h) Surface treatment agent]

Further, in the silicone composition, a surface treatment agent can be included in addition to the above-described components. The surface treatment agent is a component for a hydrophobizing treatment of the heat conductive filler, which is component (b), during preparation of the composition to improve wettability on the organopolysiloxane, which is component (a), in the composition (A), or on the silicone resin, which is component (f), in the composition (B) so that the heat conductive filler is dispersed homogeneously in a matrix comprising the component (a) or the component (f). As the surface treatment agent, preferred components are the following components (h-1) and (h-2).

(h-1) An alkoxysilane compound is represented by the following general formula (2):

   R²ₘR³nSi(OR⁴)₄₋ₘ₋ₙ .... (2)

   (in the formula (2), R² is independently an alkyl group having 6 to 15 carbon atoms, R³ is independently an unsubstituted or substituted monovalent hydrocarbon group having 1 to 8 carbon atoms, R⁴ is independently an alkyl group having 1 to 6 carbon atoms, m is an integer of 1 to 3, n is 0, 1, or 2, and m + n is an integer of 1 to 3.).
(h-2) A dimethylpolysiloxane, in which one end of the molecular-chain is capped with a trialkoxysilyl group, is represented by the following general formula (3): 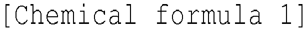 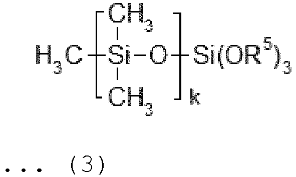 (in the above-described formula (3), R⁵ is independently an alkyl group having 1 to 6 carbon atoms, which is the same kind as the alkyl group represented by R⁴ in the above-described (2). Further, k is an integer of 5 to 100.).

First, the component (h-1) is described.

Examples of an alkyl group represented by R² in the above-described general formula (2) include a hexyl group, an octyl group, a nonyl group, a decyl group, a dodecyl group, a tetradecyl group, and the like. As described above, when the number of carbon atoms in the alkyl group represented by R² is in the range of from 6 to 15, wettability of the heat conductive filler, which is component (b), is sufficiently improved, and then pleasant workability in handling is achieved, and thus low-temperature characteristics of the composition are satisfactory.

Further, examples of the unsubstituted or substituted monovalent hydrocarbon group represented by the above-described R³ include an alkyl group, such as a methyl group, an ethyl group, a propyl group, a hexyl group, and an octyl group; a cycloalkyl group, such as a cyclopentyl group, and a cyclohexyl group; an alkenyl group, such as a vinyl group, and an allyl group; an aryl group, such as a phenyl group, and a tolyl group; an aralkyl group, such as a 2-phenylethyl group, and a 2-methyl-2-phenylethyl group; and a halogenated hydrocarbon group, such as a 3,3,3-trifluoropropyl group, a 2-(nonafluorobutyl)ethyl group, a 2-(heptadecafluorooctyl)ethyl group, and a p-chlorophenyl group. In the present invention, among the above-described groups, a methyl group and an ethyl group are specifically preferred.

Examples of the alkyl group represented by the above-described R⁴ include a methyl group, an ethyl group, a propyl group, a butyl group, a pentyl group, and a hexyl group. In the present invention, among the above-described groups, a methyl group and an ethyl group are specifically preferred.

Specific preferred examples of the above-described component (h-1) include:
C₆H₁₃Si(OCH₃)₃
C₁₀H₂₁Si(OCH₃)₃
C₁₂H₂₅Si(OCH₃)₃
C₁₂H₂₅Si(OC₂H₅)₃
C₁₀H₂₁Si(CH₃)(OCH₃)₂
C₁₀H₂₁Si(C₆H₅)(OCH₃)₂
C₁₀H₂₁Si(CH₃)(OC₂H₅)₂
C₁₀H₂₁Si(CH=CH₂)(OCH₃)₂
C₁₀H₂₁Si(CH₂CH₂CF₃)(OCH₃)₂.

One type of the above-described component (h-1) can be used alone, or two or more types can be used in combination. When the amount of the component (h-1) included is over the amount described below, the wetting effect is not further improved, and thus it is uneconomical. Further, because the component is volatile, the composition and the cured material after curing are gradually hardened when it is left in an open system. Thus, the component should preferably be included in the minimum necessary amount.

Next, the component (h-2) is described.

Specific preferred examples of the above-described component (h-2) include:

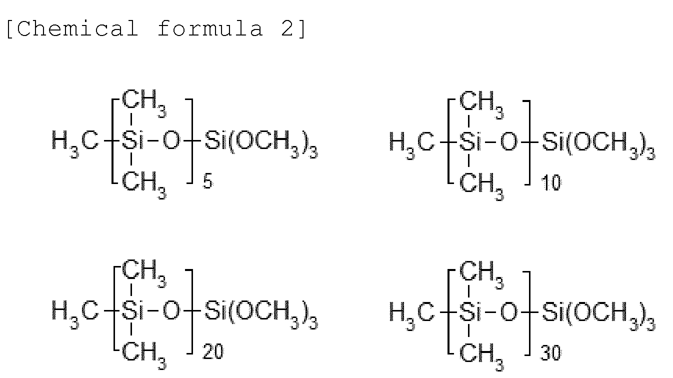

Note that, one type of the component (h-2) can be used alone, or two or more types can be used in combination. When the amount of component (h-2) included is over the amount described below, a heat-resistant property or a wet-resistant property of the obtained cured material tends to be reduced.

In the present invention, as the surface treatment agent, which is component (b), at least one kind of agent can be selected from the group consisting of the above-described component (h-1) and component (h-2), and the selected agent can be adopted and used. In this case, in the composition (A), an amount of the component (h) included in total is preferably 0.01 to 50 parts by mass, specifically preferably 0.1 to 30 parts by mass based on 100 parts by mass of the component (a). Further, in the composition (B), an amount of the component (h) included in total is preferably 0.01 to 50 parts by mass, specifically preferably 0.1 to 30 parts by mass based on 100 parts by mass of the component (f).

In the present invention, as other optional ingredients, for example, fluorine-modified silicone surfactant; and carbon black, titanium dioxide, or the like as a colorant can be included. In addition, for preventing sedimentation of or reinforcement of the heat conductive filler, micronized silica such as precipitated silica and pyrogenic silica, a thixotropy improver, or the like can be suitably added as desired.

The heat conductive silicone composition can be prepared by mixing the above-described components (a) to (d), or (b), (f), and (g), and other components as required according to a conventional method.

Note that, a curing condition of the heat conductive silicone composition can be the same as the known conditions for an addition reaction curing silicone rubber composition and an organic peroxide curing silicone rubber composition.

Examples and Comparative Examples of the heat dissipation sheet 10 are shown below. However, the present invention should in no way be construed as being limited to the following Examples.

In describing Examples and Comparative Examples, a method for forming a heat conductive composite sheet is described below.

### (Heat conductive layer)

Aluminum foil: thickness of 50 µm, heat conductivity in a plane direction of 236 W/mK
Copper foil: thickness of 30 µm, heat conductivity in a plane direction of 398 W/mK

### (Heat radiation sheet comprising heat radiation layer laminated to heat conductive layer)

(1-1) : A heat radiation sheet comprising Cerac α (heat radiation layer; a silicone resin comprising alumina having a heat radiation rate of 0.96, and an average particle size of 5 µm, manufactured by CERAMISSION CO., LTD.) laminated at a thickness of 50 µm onto aluminum foil (heat conductive layer; a thickness of 50 µm).
(1-2) A heat radiation sheet comprising Cerac α (heat radiation layer; a heat radiation rate of 0.96, manufactured by CERAMISSION CO., LTD.) laminated at a thickness of 30 µm onto copper foil (heat conductive layer; a thickness of 30 µm).
(1-3) MORGEN sheet MG01-S (manufactured by Asari Denki Co, Ltd.; a heat radiation sheet comprising a heat radiative polyethylene resin (a polyester resin comprising graphite having an average particle size of 1 µm) having a thickness of 30 µm, and a heat radiation rate of 0.99 laminated onto aluminum foil having a thickness of 60 µm, and a heat conductivity of 230 W/mK.)

### (Heat conductive silicone resin layer (base))

(II-1) to (II-4): A heat conductive silicone resin layer (base) having ASKER C hardness and heat conductivity as shown in the table below.

The heat conductive composite sheet (radiation sheet) was obtained by pasting the above-described heat radiative sheet and the above-described heat conductive silicone resin layer (base) together.

For comparison, (II-5) a non-heat-conductive silicone resin layer (heat conductivity: 0.16 WmK), (II-6) a heat conductive silicone double-sided adhesive tape (heat conductivity: 1.0 W/mK), and (II-7) an acrylic double-sided adhesive tape were pasted on the heat radiation sheet, and the resultants were also used.

Components of compositions (ii-1) to (ii-7) constituting the resin layer (II-1) to (II-7) are shown below.

### [(a) Alkenyl group-containing organopolysiloxane]

The following formula 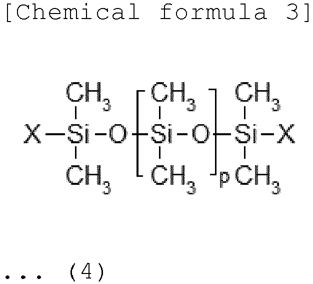 (an organopolysiloxane in which X is a vinyl group, and p is a number determined so that kinematic viscosity of the organopolysiloxane at 25°C is the value shown below)
(a-1) Viscosity: 600 mm²/s
(a-2) Viscosity: 30,000 mm²/s

### [(b) Heat conductive filler]

(b-1) Aluminum hydroxide powder having an average particle size of 30 µm
(b-2) Aluminum oxide powder having an average particle size of 50 µm
(b-3) Aluminum oxide powder having an average particle size of 10 µm

### [(c) Organohydrogenpolysiloxane]

An organohydrogenpolysiloxane represented by the following formula 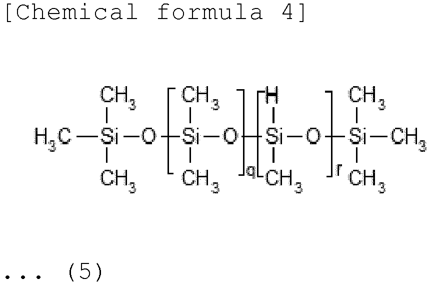 (wherein the average degree of polymerization: q = 28, and r = 2)

### [(d) Platinum group compound]

A solution of 5 mass% chloroplatinic acid in 2-ethylhexanol

### [(e) Reaction controlling agent]

Ethynyl methylidene carbinol

### [(f) Silicone resin]

A solution of a silicone resin consisting only of Me₃SiO_{0.5} unit (M unit) and SiO₂ unit (Q unit) (wherein Me represents a methyl group. M/Q molar ratio is 1.15.) in toluene (nonvolatile component: 60 mass%, viscosity: 30 mm²/s)

### [(h) Surface treatment agent]

A dimethylpolysiloxane having the average degree of polymerization of 30, in which one end is capped with a trimethoxysilyl group represented by the following formula

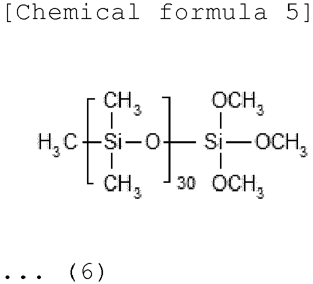

**[Table 1]**

| Components (parts by mass) | | (ii-1) | (ii-2) | (ii-3) | (ii-4) | (ii-6) |
|---|---|---|---|---|---|---|
| (a) Alkenyl group-containing organopolysiloxane | (a-1) | 100 | 100 | 80 | 80 | 100 |
| | (a-2) | | | 20 | 20 | |
| (b) Heat conductive filler | (b-1) | 800 | 800 | | 300 | 800 |
| | (b-2) | | | 1000 | 500 | |
| | (b-3) | | | 1000 | | |
| (c) Organohydrogenpolysiloxane | | 10 | 6 | 4 | 4 | 10 |
| (d) Platinum group compound | | 0.1 | 0.1 | 0.08 | 0.08 | 0.1 |
| (e) Reaction controlling agent | | 0.05 | 0.05 | 0.1 | 0.1 | 0.05 |
| (f) Silicone resin | | | | | 60 | 75 |
| (h) Surface treatment agent | | 15 | 15 | 40 | 40 | 10 |
| Hardness of resin layer (ASKER C) | | 30 | 10 | 20 | 30 | 60 |
| Heat conductivity of resin layer (W/mK) | | 1.8 | 1.8 | 4.5 | 4.5 | 1.0 |

### Silicone composition (ii-5)

A silicone adhesive material composition containing the following (α) to (ζ) at a mass ratio of 65/20/0.05/0.15/0.1/14.7
(α) A solution of a silicone resin consisting only of Me₃SiO_{0.5} unit (M unit) and SiO₂ unit (Q unit) (wherein Me represents a methyl group. M/Q molar ratio is 1.15.) in toluene (nonvolatile component: 60 mass%; viscosity: 30 mm²/s)
(β) Dimethylpolysiloxane in which both ends are capped with dimethylvinyl groups having the average degree of polymerization of 8,000
(γ) Ethynyl methylidene carbinol
(δ) Organohydrogenpolysiloxane of the formula (5) in which q = 1, and r = 40
(ε) A solution of 5 mass% chloroplatinic acid in 2-ethylhexanol
(ζ) Toluene

### Composition (ii-7)

An acrylic resin composition containing the following (η) to (ι) at a ratio of 97/3/0.03
(η) 2-Ethylhexyl acrylate
(θ) Acrylic acid
(ι) Hexanediol diacrylate

Note that, the above-described resin compositions were obtained by kneading with a planetary mixer.

### [Method for forming resin layer]

(ii-1) to (ii-3) : The obtained composition was flowed on a fluorinated film, and then cured under pressure under conditions of 120°C/10 minutes using a mold to achieve a desired thickness.
(ii-4) to (ii-6) : The obtained composition was painted on a fluorinated film to achieve a desired thickness, and then solvents were dried under conditions of 80°C/10 minutes, and the resultant was cured under conditions of 120°C/10 minutes.
(ii-7): The obtained composition was painted on a fluorinated film, and then the resultant was cured with UV light having a center wavelength of 360 nm emitted from a UV lamp.

### [Method for evaluating composite sheet]

Composite sheets were prepared by pasting various heat radiation sheets and various resin layers together, and then the composite sheets were evaluated by the following method for evaluation.

An aluminum plate (size: 30 × 120 mm, thickness: 2 mm) was heated by providing electrical power of 15 W. When the temperature of the aluminum plate reached a steady-state (64 to 66°C), a composite sheet (size: 30 × 100 mm) was pasted on the aluminum plate. Then, 1 minute later, the temperature of the aluminum plate was measured. In this connection, the measurement was carried out under a measurement environment at 25 ± 2°C, and a humidity of 50% ± 5%.

### [Examples 1 to 7, Comparative Examples 1 to 5]

As in Examples 1 to 7, to a heat radiation sheet comprising the heat radiation layer having a thickness of 10 to 100 µm and preferably having a heat radiation rate of 0.80 or more laminated to the heat conductive layer having an in-plane heat conductivity of 200 W/mK or more, a heat conductive silicone resin layer having hardness of 40 or less in ASKER C and preferably having a heat conductivity of 1.4 W/mK is laminated, at a heat conductive layer side of the heat radiation sheet, at a thickness of 0.2 mm or more to provide a temperature-lowering effect on a heat source. Especially, a heat conductive silicone layer having a higher heat conductivity and a larger thickness provides a higher temperature-lowering effect on a heat source.

As in Comparative Examples 1 and 2, when a silicone resin layer having an extremely low heat conductivity is laminated to the heat radiation sheet, it is not possible efficiently to transfer a heat from a heat source to the heat radiation layer. As in Comparative Examples 2 and 4, when ASKER C hardness is over 40, the temperature-lowering effect is lowered. As in Comparative Example 5, when the acrylic double-sided adhesive tape is used, it is not possible efficiently to transfer a heat from a heat source to the heat conductive layer. Further, since an acrylic resin has a lower heat-resistant property as compared to a silicone resin, there is an anxiety about long-term reliability in use at a portion that is directly contact with a heat source.

**[Table 2]**

| Example | 1 | 2 | 3 | 4 | 5 | 6 | 7 |
|---|---|---|---|---|---|---|---|
| Heat radiation sheet | I-1 | I-2 | I-3 | I-3 | I-3 | I-3 | I-3 |
| Heat conductive silicone resin layer | II-1 | II-2 | II-1 | II-3 | II-3 | II-4 | II-4 |
| Thickness of heat conductive silicone resin layer (mm) | 0.5 | 3.0 | 0.5 | 0.5 | 3.0 | 0.5 | 3.0 |
| Temperature after 1 minute (°C) | 60 | 50 | 58 | 59 | 49 | 57 | 48 |

**[Table 3]**

| Comparative Example | 1 | 2 | 3 | 4 | 5 |
|---|---|---|---|---|---|
| Heat radiation sheet | I-1 | I-2 | I-1 | I-2 | I-1 |
| Resin layer | II-5 | II-5 | II-6 | II-6 | II-7 |
| Thickness of resin layer (mm) | 0.1 | 0.1 | 0.3 | 0.1 | 0.1 |
| Temperature after 1 minute (°C) | 63 | 62 | 62 | 62 | 63 |

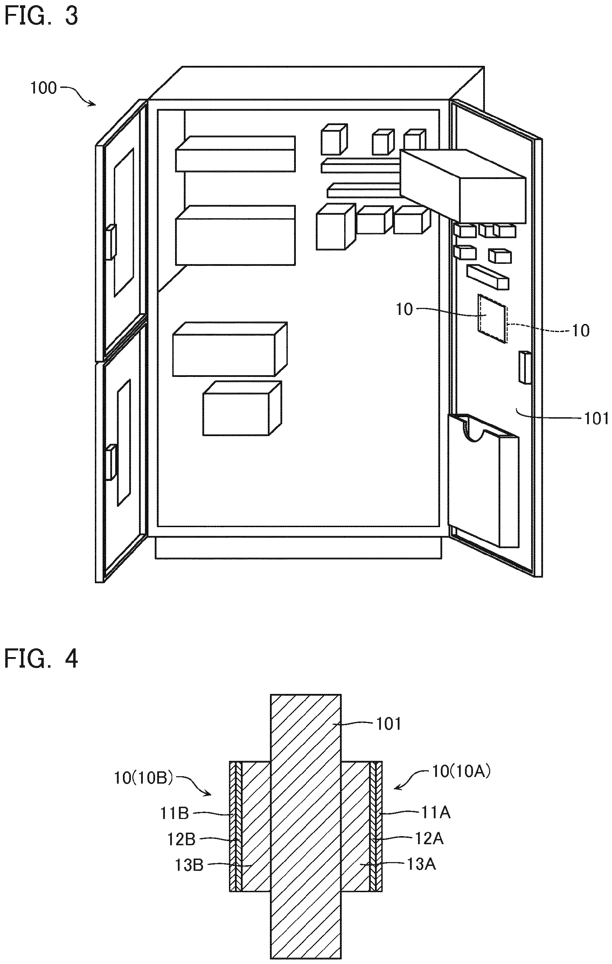

Next, a method of heat dissipation for an apparatus using the heat dissipation sheet 10 having the above-described structure is described with reference to Fig. 3 to Fig. 5.

Fig. 3 represents an example of an internal structure of the control panel 100 as shown in Fig. 2. As shown in Fig. 3, the control panel 100 is internally equipped with a lot of parts, such as various circuit boards, a transformer, a power source, a servo amplifier, or an electric motor which are heat generation sources. Conventionally, a cooling apparatus, such as a cooler, a cooling fan, a heat sink, or the like is used to dissipate heat generated by such circuit boards or the like. However, such cooling apparatuses have problems that it is not easy for maintenance, and their running costs are too high to ignore, and further, a large space for installation is required.

However, in the present embodiment, as shown in Fig. 3, the above-described heat dissipation sheets 10 are pasted on, for example, the front side and the reverse side of the wall 101 of the housing of the control panel 100 to oppose each other via the wall 101 to cool the control panel 100.

Fig. 4 is a schematic diagram of a pasting portion showing a method for pasting the heat dissipation sheet 10. In the embodiment, two sheets, which are heat dissipation sheets 10A and 10B, are provided (step S1). Then, the heat dissipation sheet 10A is pasted on the front side of the wall 101 (step S2), and the other heat dissipation sheet 10B is pasted on the reverse side of the wall 101 at a position opposing the heat dissipation sheet 10A via the wall 101 (step S3). At this time, each of the heat dissipation sheet 10A and the heat dissipation sheet 10B is pasted so that the heat conductive base 13 side faces the wall 101 side. As described above, the heat dissipation sheets 10A and 10B are pasted on the wall 101 to dissipate heat of the control panel 100. Further, the area of the heat dissipation sheet 10 is, for example, preferably set as having sufficiently larger area than the area of a heat-generating portion (e.g., a servo amplifier) which is a target of heat dissipation. For example, the area of the heat dissipation sheet 10 is preferably set at 10 or more times as large as the area of the heat-generating portion. Consequently, a heat dissipation effect can be further improved.

An action of the method of heat dissipation of the present embodiment is described below.
(1) When a heat from a heat generation source in the control panel 100 is radiated to the wall 101, a heat radiation layer 11B of a heat dissipation sheet 10A pasted on the reverse side of the wall 101 absorbs the radiated heat.
(2) The heat absorbed in the heat radiation layer 11B is conducted to a heat conductive layer 12B, and then the heat is conducted to a heat conductive base 13B.
(3) The heat conductive base 13B transfers the heat conducted from the heat conductive layer 12B through the wall 101 to the heat dissipation sheet 10A pasted on the front side surface of the wall 101.
(4) A heat conductive base 13A of the heat dissipation sheet 10A absorbs the heat conducted to the wall 101.
(5) The heat absorbed in the heat conductive base 13A is conducted to a heat conductive layer 12A.
(6) Then, the heat conducted to the heat conductive layer 12A is further conducted to a heat radiation layer 11A, and then the heat is dissipated to the outside.

As a result of the above-described heat transfer of (1) to (6), the internal heat of the control panel 100 is dissipated to the outside, and thus the temperature of the inside of the control panel 100 goes down.

The heat dissipation sheet can be formed with the above-described materials, and maintains the effect for a long period of time, and further does not require a maintenance such as applying silicone grease which is required in a heat sink. Accordingly, the method of heat dissipation using the heat dissipation sheet provides heat dissipation of an apparatus with low in cost and no complicated maintenance.

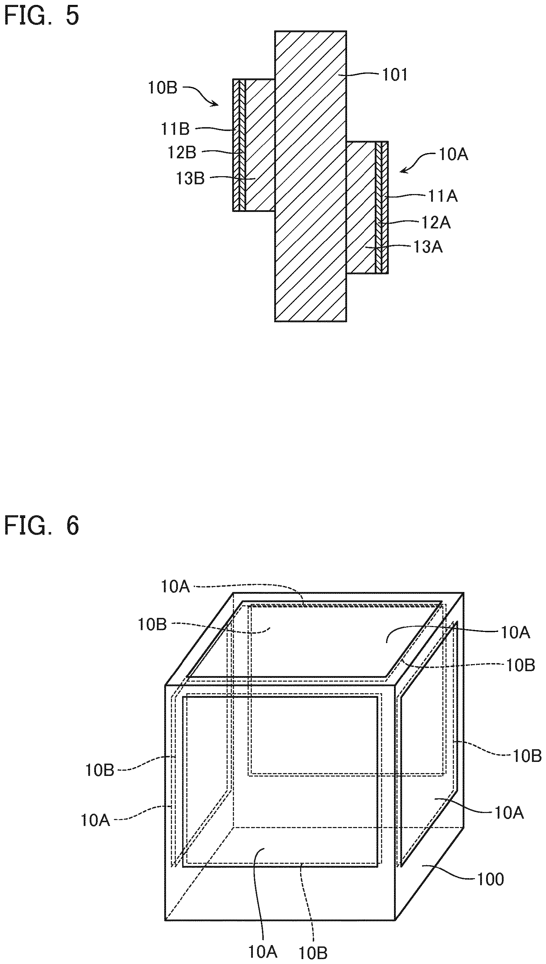

Note that, the heat dissipation sheets 10A and 10B, which are placed on the front side and the reverse side of the wall 101 to oppose each other via the wall 101, are preferably pasted so that at least portions of the heat dissipation sheets 10A and 10B are overlapped. Ideally, the heat dissipation sheets 10A and 10B are perfectly overlapped as shown in Fig. 4. However, when only portions of the heat dissipation sheets 10A and 10B are overlapped as shown in Fig. 5, a certain effect can be achieved. Note that, the heat dissipation sheets 10A and 10B can be pasted on the front side/the reverse side of only one wall 101 of a housing of a control panel 100. The heat dissipation sheets 10A and 10B can be pasted on the ceiling panel, and two or more side walls as shown in Fig. 6. If possible, the heat dissipation sheets 10A and 10B can be pasted on the front side and the reverse side of the bottom panel of the housing.

As described above, the control panel 100 is internally equipped with a lot of internal parts, such as the various circuit boards, the transformer, the power source, the servo amplifier, or the electric motor which are heat generation sources. Thus, the heat dissipation sheets 10A and 10B can be pasted on the front side and the reverse side of a wall of a housing close to a heat generation source to cool the control panel without using a cooling apparatus such as a cooler, a cooling fan, or a heat sink. The method of heat dissipation of the present embodiment is effective not only for the exemplified control panels but also for an apparatus internally equipped with an internal part which is a heat generation source, specifically for an apparatus internally equipped with two or more such internal parts.

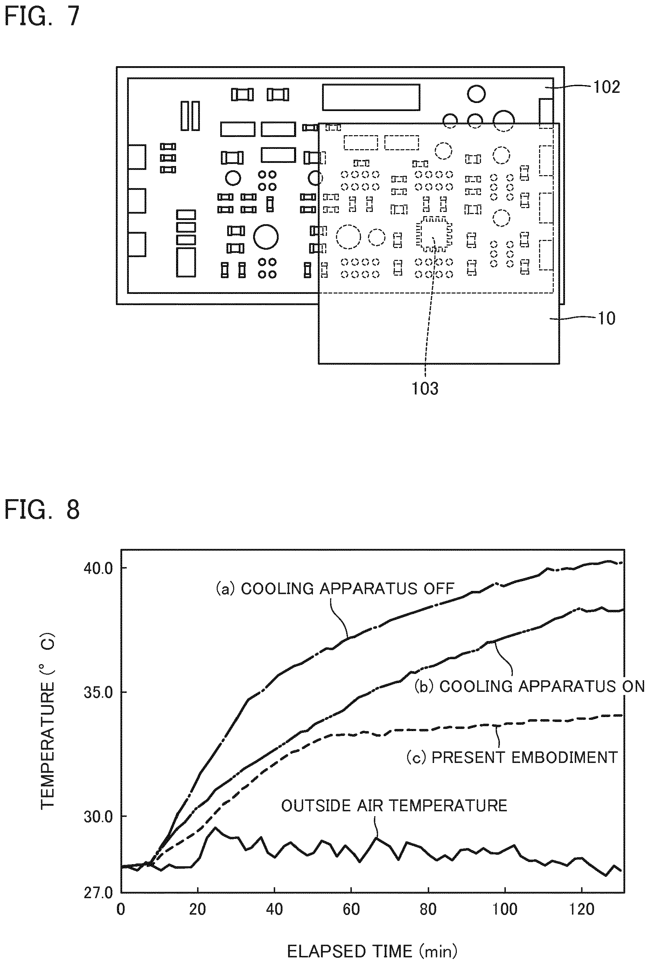

The method of heat dissipation for the control panel 100 having the housing is described above. However, the method of heat dissipation of the present invention is not limited only to heat dissipation for a such apparatus having a housing. For example, as shown in Fig. 7, when there is an electronic substrate 102 having a heat generation source, the heat dissipation sheet 10 can be pasted directly on a heat-generating portion (e.g., a CPU 103) of the electronic substrate 102 to cool the electronic substrate 102.

In this connection, an area of the heat dissipation sheet 10 is preferably set at 10 or more times as large as the area, for example, of the heat-generating portion (e.g., a CPU 103) which is a target of heat dissipation. Consequently, a heat dissipation effect can be further improved.

Fig. 8 is a graph showing an effect of the method of heat dissipation using the heat dissipation sheet of the present embodiment. The horizontal axis indicates the time elapsed from the start of operation of the control panel 100, and the vertical axis indicates the temperature of the inside of the control panel 100.

For comparison, temperature changes when (a) a cooling apparatus such as a cooling fan was OFF and when (b) the cooling apparatus was ON, are shown together.

In a condition (a) in which the cooling apparatus was OFF and thus the cooling apparatus did not operate, the temperature of the inside of the control panel 100 gradually went up. After 120 minutes from the start of operation, the temperature went up about 12 degree as compared to the temperature before the start of operation.

Further, when the cooling apparatus was ON, an extent of rise in temperature was suppressed. However, after 120 minutes from the start of operation, the temperature went up almost 10 degree as compared to the temperature before the start of operation.

On the other hand, when the heat dissipation sheet of the present embodiment was used, a rise in temperature was reduced to almost half of that with the cooling apparatus. Further, the method of heat dissipation using the heat dissipation sheet has an advantage of low in cost and almost free from maintenance.

Although some of embodiments of the present invention are described above, the embodiments are provided as examples, and are not intended to be limiting the scope of the invention. The novel embodiments can be carried out in other various forms, and various omission, replacement, and alteration are possible without departing from the spirit of the invention. Such embodiments and their modifications are included in the scope and spirit of the invention, and included in the invention and equivalents to the invention set forth in CLAIMS.

### Reference Signs List

- 10: Heat dissipation sheet
- 11: Heat radiation layer
- 12: Heat conductive layer
- 13: Heat conductive base
- 100: Control panel (Electrical apparatus)
- 101: Wall
- 102: Circuit board
- 103: CPU

## Claims

1. A method of heat dissipation for an apparatus having a heat generation source inside a housing, comprising:
pasting a first heat dissipation sheet on an internal wall surface of a wall of the housing; and
pasting a second heat dissipation sheet on an external wall surface of the wall of the housing so that the wall of the housing is positioned between the first heat dissipation sheet and the second heat dissipation sheet, wherein
the first and the second heat dissipation sheets include a heat conductive layer, a heat radiation layer adjacent to a first surface of the heat conductive layer, and a base adjacent to a second surface of the heat conductive layer, and
the base contains a heat conductive silicone resin having hardness of 40 or less in ASKER C.

2. The method of heat dissipation according to claim 1, wherein
the first heat dissipation sheet and the second heat dissipation sheet are pasted on the wall surfaces so that the bases are contact with the wall surfaces.

3. The method of heat dissipation according to claims 1 or 2, wherein
the first heat dissipation sheet or the second heat dissipation sheet is pasted on the wall close to the heat generation source.

4. A method of heat dissipation for an apparatus having a heat generation source, comprising:
pasting a first heat dissipation sheet directly on the heat generation source, wherein
the heat dissipation sheet includes a heat conductive layer, a heat radiation layer adjacent to a first surface of the heat conductive layer, and a base adjacent to a second surface of the heat conductive layer, and
the base contains a heat conductive silicone resin having hardness of 40 or less in ASKER C.

5. The method of heat dissipation according to claim 4, wherein
the heat dissipation sheet has an area 10 or more times as large as the area of the heat generation source.

6. The method of heat dissipation according to any of claims 1 to 5, wherein
the base has a thickness of 0.2 mm or more.

7. The method of heat dissipation according to any of claims 1 to 6, wherein
the heat conductive layer has a heat conductivity in a plane direction of 200 W/mK or more.

8. The method of heat dissipation according to any of claims 1 to 7, wherein
the heat radiation layer has a thickness of 10 µm or more and 100 µm or less.

9. The method of heat dissipation according to any of claims 1 to 8, wherein
the base has a heat conductivity of 1.4 W/mK or more.

10. The method of heat dissipation according to any of claims 1 to 9, wherein
the base is a cured material of a heat conductive silicone composition comprising:
(a) an organopolysiloxane having 2 or more alkenyl groups bonded to silicon atoms per molecule, wherein the organopolysiloxane is represented by an average composition formula RₐSiO_{(4-a)/2} (wherein R is independently an unsubstituted or substituted monovalent hydrocarbon group having 1 to 12 carbon atoms, a is a positive number of 1.8 to 2.2) (100 parts by mass);
(b) a heat conductive filler: 200 to 4000 parts by mass;
(c) an organohydrogenpolysiloxane having 2 or more hydrogen atoms bonded to silicon atoms per molecule (an amount in which a molar ratio of hydrogen atoms directly bonded to the silicon atoms in the component (c) relative to the alkenyl groups in the component (a) is 0.5 to 5.0); and
(d) a platinum group compound (0.1 to 1000 ppm of the component (a) as a platinum group element content).

11. The method of heat dissipation according to claim 10, wherein
the heat conductive silicone composition further comprising (f) a silicone resin (50 to 500 parts by mass).

12. The method of heat dissipation according to any of claims 1 to 9, wherein
the base is a cured material of a heat conductive silicone composition comprising:
(b) a heat conductive filler (100 to 3000 parts by mass),
(f) a silicone resin (100 parts by mass), and
(g) organic peroxide compounds (0.1 to 2 parts by mass calculated as an organic peroxide).

13. The method of heat dissipation according to claim 12, wherein
the (f) silicone resin is a copolymer of R¹₃SiO_{1/2} unit (wherein R¹ represents an unsubstituted or substituted monovalent hydrocarbon group) (M unit) and SiO_{4/2} unit (Q unit), in which a molar ratio between M unit and Q unit (M/Q) is 0.5 to 1.5, and the silicone resin contains no aliphatic unsaturated combination.

14. The method of heat dissipation according to any of claims 1 to 13, wherein
the apparatus is a control panel internally equipped with at least one of a circuit board, a transformer, a power source, a servo amplifier, and an electric motor as internal parts.
